# EUROPÄISCHE PATENTANMELDUNG

(11) **EP 3 859 778 A1**
(43) Veröffentlichungstag der Anmeldung: **04.08.2021**
(21) Anmeldenummer: 20155104.1
(22) Anmeldetag: 03.02.2020
(51) Int. Cl.: H01L 23/64, H03K 17/0814, H01G 4/01

(54) **SCHNELLER ELEKTRONISCHER SCHALTER**

(71) Anmelder: Siemens Aktiengesellschaft, 80333 München (DE)
(72) Erfinder: Haensel, Stefan, 91083 Baiersdorf (DE); Reimann, Oliver, 91056 Erlangen (DE)

(57) **Zusammenfassung**

Es wird ein Schalter (1), insbesondere für den Einsatz als DC-Schalter, aus einem abschaltbaren Halbleiterschalter (21) und einer Reihenschaltung (10) angegeben, wobei die Reihenschaltung parallel zum abschaltbaren Halbleiterschalter angeordnet ist und einen ersten Widerstand (4a), einen Kondensator (3) und einen zweiten Widerstand (4b) umfasst, wobei der erste und zweite Widerstand zusammen als bifilarer Widerstand (4) aufgebaut sind, um eine besonders niederinduktive Kommutierungsschleife zu bilden.

## Beschreibung

Die Erfindung betrifft einen elektronischen Schalter mit mindestens einem abschaltbaren Halbleiterschalter und einer parallel zum Halbleiterschalter angeordneten Reihenschaltung, die einen Kondensator zur Aufnahme von Energie beim Abschaltvorgang umfasst.

Die Versorgung mit elektrischer Energie findet heutzutage in erster Linie über Wechselspannungsnetze statt. Diese haben den Vorteil, dass sich unterschiedliche Spannungsebenen mit Hilfe von Transformatoren herstellen lassen. Durch Halbleiter, die immer kostengünstiger am Markt verfügbar sind, lassen sich auch für DC Netze auf einfache Weise unterschiedliche Spannungsebenen erzeugen, so dass gerade auch die Energieversorgung über DC Netze, insbesondere innerhalb von Industrienetzen, besonders wirtschaftlich wird.

DC-Netze sollen dabei in zukünftigen Industrieanlagen Verluste reduzieren, den direkten Energieaustausch zwischen Umrichtern, Energiespeichern und Lasten gewährleisten und eine erhöhte Robustheit erzielen. Dabei können beispielsweise kleine DC Netze mit unterschiedlichen Kabellängen zwischen den verschiedenen Lastabgängen und Einspeisungen betrieben werden. Die geringen Kabellängen führen zu sehr kleinen Längsinduktivitäten in den Zuleitungen, so dass Fehlerströme sehr steile Stromanstiege aufweisen können. Ebenso fehlt in Gleichstromnetzen der in Wechselstromnetzen vorhandene Blindwiderstand, der den Maximalstrom eines Kurzschlusses begrenzt. Dies macht eine sehr schnelle Fehlererkennung und Abschaltung für den Fehlerfall erforderlich. Diese Forderungen können mechanische Schalter oftmals nicht erfüllen. Deshalb werden sogenannte elektronische Schalter mit Halbleiterschaltern eingeführt. Diese werden auch als Solid State Breaker bezeichnet. Diese Schalter zeichnen sich im Gegensatz zu mechanischen Schaltern durch besonders schnelles Schalten, typischerweise in der Größenordnung von 100ns, aus.

Aus der EP 3 367 567 A1 ist eine Schaltvorrichtung zum Auftrennen eines Strompfads bekannt. Dieses Dokument betrifft eine Schaltvorrichtung zum Auftrennen einer quell- und lastseitigen Induktivität umfassenden Strompfads eines Gleichspannungsnetzes. Die Schaltvorrichtung umfasst zumindest zwei in Serie verschaltete Schaltmodule, wobei jedes der Schaltmodule zumindest ein steuerbares Halbleiterschaltelement umfasst, dem eine Serienschaltung aus einem Widerstand und einem Kondensator parallelgeschaltet ist.

Der Erfindung liegt die Aufgabe zugrunde, einen elektronischen Schalter, insbesondere hinsichtlich seines Schaltverhaltens, zu verbessern. Diese Aufgabe wird durch einen elektronischen Schalter mit den Merkmalen von Anspruch 1 gelöst.

Der erfindungsgemäße elektronische Schalter umfasst einen abschaltbaren Halbleiterschalter und eine Reihenschaltung, die parallel zum abschaltbaren Halbleiterschalter angeordnet ist und einen ersten Widerstand, einen Kondensator und einen zweiten Widerstand umfasst. Dabei sind der erste und zweite Widerstand zusammen als bifilarer Widerstand aufgebaut.

Bei dem abschaltbaren Leistungshalbleiterschalter kann es sich um einen Schalter handeln, der einen Strom nur in eine Richtung abschalten kann. Dieser ist insbesondere für Lasten geeignet, die nicht rückspeisefähig sind und damit auch nur Strom in eine Richtung führen. Ebenso kann es sich um einen abschaltbaren Leistungshalbleiterschalter handeln, der einen Strom in beide Richtungen abschalten kann.

Der abschaltbare Halbleiterschalter ist empfindlich gegenüber Spannungsspitzen, die beim Schalten, insbesondere beim Abschalten, des Stroms auftreten. Durch die vorhandenen Induktivitäten im DC-Netz, beispielsweise aufgrund von parasitären Induktivitäten der Kabel, führen Stromänderungen und speziell Stromunterbrechungen zu hohen Spannungen, die dann teilweise über den abschaltbaren Halbleiterschalter abfallen und diesen beschädigen oder seine Lebensdauer herabsetzen können. Durch die parallel angeordnete Reihenschaltung aus Kondensator und bifilarem Widerstand kann der abschaltbare Halbleiterschalter zuverlässig vor entstehenden Überspannungen und Spannungsspitzen geschützt werden.

Dabei wird ein Übergang vom sperrenden in den leitenden Zustand eines Schalters als Einschalten und ein Übergang vom leitenden in den sperrenden Zustand eines Schalters als Ausschalten oder Abschalten bezeichnet.

In Abhängigkeit seiner Strom-Spannungskennlinie fällt ein Teil der beim Abschalten des abschaltbaren Halbleiterschalters entstehenden Spannung über dem Widerstand ab, der andere Teil über dem Kondensator. Dadurch baut sich im Kondensator eine Spannung auf, welche sich zu der Spannung des Widerstands addiert. Der Laststrom sinkt durch die aufgebrachte Gegenspannung des Kondensators nach der Gleichung u(t)= L*di/dt und wegen des Verhaltens des Kondensators mit i(t)=C*du/dt baut sich mehr und mehr eine Gegenspannung über dem Kondensator auf. Auf jeden Fall wird dadurch eine Gegenspannung erzeugt, die größer ist als die treibende DC-Spannung, da durch den Stromfluss durch den Kondensator eine Gegenspannung aufgebaut wird, die zwangsläufig und zuverlässig nach einer gewissen Zeit den Stromfluss unterbindet.

In vorteilhafter Weise wird durch den erfindungsgemäßen Aufbau ein elektronischer Schalter, insbesondere für DC-Verbindungen, geschaffen, bei dem der Widerstand, der in Reihe zum parallelen Kondensator angeordnet ist, besonders niederinduktiv ist. Dadurch wird ein elektronischer Schalter geschaffen, der auch hohe Kurzschlussströme schnell in den Kondensator kommutieren kann und daher diese Kurzschlussströme besonders schnell abschalten kann.

Besonders vorteilhaft ist der Einsatz des elektronischen Schalters in DC-Netzen auf Mittelspannungsniveau, also im Bereich einiger kV Spannung und bei Strömen, die zumindest bei einem Kurzschluss im Bereich einiger kA liegen. Der Schalter kann aber auch in DC-Netzen auf Niederspannungsniveau, also weniger als 1500 V Gleichspannung verwendet werden. Es handelt sich also bevorzugt um einen Elektronischen DC-Schalter.

Für den niederinduktiven Aufbau ist es wichtig, dass der erste und der zweite Widerstand, die zusammen den bifilaren Widerstand bilden, elektrisch zu beiden Seiten des Kondensators angeordnet sind, also mit anderen Worten die Reihenfolge erster Widerstand, Kondensator, zweiter Widerstand eingehalten wird, da nur so der niederinduktive Aufbau erreicht werden kann. Bei diesem sind der erste und zweite Widerstand physisch so nebeneinander angeordnet, dass die Richtung des elektrischen Stroms in beiden Widerständen entgegengesetzt zueinander ist. Dadurch heben sich die entstehenden magnetischen Felder weitgehend auf und das Gesamtbauteil, also der bifilare Widerstand erreicht eine sehr niedrige Induktivität.

Vorteilhafte Ausgestaltungen der erfindungsgemäßen Einrichtung gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können für den elektronischen Schalter noch zusätzlich folgende Merkmale vorgesehen werden:
- Der bifilare Widerstand kann eine Eisenlegierung, insbesondere V4A-Stahl, umfassen. V4A-Stahl soll dabei für CrNiMo-Stahl stehen. Diese Eisenlegierungen sind einerseits nichtmagnetisch und haben andererseits einen im Vergleich zu Kupfer oder Aluminium deutlich höheren spezifischen Widerstand, was den Aufbau des bifilaren Widerstands deutlich erleichtert. Alternativ kann der bifilare Widerstand als Material andere Widerstandslegierungen wie beispielsweise Konstantan umfassen, insbesondere aus dem Material bestehen.
   Besonders vorteilhaft kann dadurch der bifilare Widerstand eine Dicke im Millimeter-Bereich aufweisen, ohne einen zu geringen elektrischen Widerstand zu bekommen. Dadurch ist eine geeignet stabile Verbindung mit dem Halbleiterschalter und dem Kondensator erreichbar. Ein bifilarer Widerstand aus Kupfer wäre hingegen folienartig dünn, da seine Breite nicht sehr klein gemacht werden kann, ohne wiederum die Induktivität zu erhöhen.
- Die beiden Widerstände, die zusammen den bifilaren Widerstand bilden, können mittels Stanzung hergestellt sein. Stanzung stellt vorteilhaft eine einfache, kostengünstige und flexible Herstellungsform dar, die auch verwendbar ist, wenn die Widerstände als Verschienung verwendet werden und die mechanische Last des Kondensatoranschlusses tragen müssen, also die Materialdicke im Bereich von mm liegt.
- Der erste und zweite Widerstand können jeweils die Form eines Rechtecks aufweisen, bei dem zwei einander gegenüberliegende Kanten zu einer Seite hin um 90° umgebogen sind. Dadurch ergibt sich für jeden der Widerstände der Querschnitt eines eckigen C oder einer eckigen Klammer [. Die beiden Widerstände werden bevorzugt mit den Rücken zueinander angeordnet, so dass sich ein Querschnitt der Form] [ergibt. Dabei dienen die umgebogenen Endstücke der Befestigung am Halbleiterschalter und am Kondensator, während die einander zugewandten Rücken den eigentlichen Widerstand ausmachen. Bei genügender Dicke des Materials, also genügender mechanischer Tragfähigkeit, kann der bifilare Widerstand neben der elektrischen Verbindung auch die einzige mechanische Verbindung zwischen dem Halbleiterschalter und dem Kondensator ausmachen.
- In einem alternativen Aufbau hat der bifilare Widerstand weiterhin einen Querschnitt der Form][, allerdings in Aufsicht nicht mehr eine rechteckige Form. Vielmehr verjüngen sich die Widerstände zum Kondensator hin, sodass die beiden Widerstände in Aufsicht die Form eines Trapezes oder eines Rechtecks mit einem angeschlossenen Trapez haben.
- In einem weiteren alternativen Aufbau haben die Widerstände einen L-förmigen Querschnitt. Die beiden Widerstände werden zur Ausbildung des bifilaren Widerstands ineinander gestellt und bilden somit eine doppelwandige L-Form aus. Ein Arm dieser L-Form kommt auf den Anschlüssen des Halbleiterschalters zu liegen und der andere Arm steht demgemäß von der Oberfläche des Halbleiterschalters ab und dient dem Anschluss des Kondensators. Hat der Kondensator eine längliche Zylinderform, so liegt seine Zylinderachse bei dieser Form der Widerstände parallel zur Oberfläche des Halbleiterschalters, anstatt von dieser senkrecht abzustehen wie im Falle der voranstehenden Alternativen mit dem Querschnitt der Form][. Dadurch ist diese Alternative platzsparend.

Allen mechanischen Anordnungen ist der bifilare Aufbau der Widerstandsfläche gemein.
- Da alle Leitungsverbindungen wieder eigene Induktivitäten in die Schaltung einbringen, umfasst der elektronische Schalter parallel zum bifilaren Widerstand bevorzugt genau einen einzigen abschaltbaren Halbleiterschalter. Stellt der Widerstand gleichzeitig die direkte elektrische Verbindung zwischen dem Halbleiterschalter und dem Kondensator dar, entfallen im Kommutierungskreis aus Halbleiterschalter, Widerstand und Kondensator praktisch alle elektrischen Leitungen, die noch eine Induktivität besitzen und beim Abschaltvorgang für hohe Spannungen sorgen und die Stromkommutierung verzögern könnten. Damit ist vorteilhaft ein niederinduktiver Kommutierungskreis geschaffen, der schon mit nur zwei Halbleiterschaltern parallel zum bifilaren Widerstand und Kondensator nur sehr schwer zu erreichen ist.
- Auch wenn der elektronische Schalter nur genau einen Halbleiterschalter enthält, können mehrere Exemplare des elektronischen Schalters zu einem Gesamtschalter zusammengesetzt werden. Beispielsweise können mehrere elektronische Schalter in Serie geschaltet werden.

- Alternativ kann der Schalter genau ein Leistungshalbleitermodul umfassen. Das Leistungshalbleitermodul ist die heute übliche Aufbauform von Leistungshalbleitern und umfasst einen oder mehrere einzelne Halbleiterschalter in einem gemeinsamen Gehäuse. In einem solchen Modul können beispielsweise zwei serielle, zwei parallele oder zwei antiserielle oder zwei antiparallele Halbleiterschalter angeordnet sein. Da die Leitungsverbindungen innerhalb eines solchen Moduls kurz sind und damit niederinduktiv, kann so ein sehr niederinduktiver Schalter geschaffen werden, auch wenn das Modul selbst mehr als einen Halbleiterschalter enthält. Beispielsweise kann so auch ein niederinduktiver bidirektionaler Schalter geschaffen werden.
- In einer weiteren Alternative umfasst der Schalter eine Mehrzahl von Leistungshalbleitern in einer Mehrzahl von Leistungshalbleitermodulen, wobei die Leistungshalbleitermodule seriell oder antiseriell geschaltet sind.
- Auf dem Markt befindliche abschaltbare Halbleiterschalter können meistens nur einen Strom in einer Richtung abschalten. Typische Vertreter für solche abschaltbaren Halbleiterschalter sind IGBTs oder MOSFETS. Will man bei der Verwendung solcher abschaltbaren Halbleiterschalter Ströme in beide Richtungen durch den Schalter abschalten können, so verwendet man zwei dieser abschaltbaren Halbleiterschalter. Damit lassen sich beide Polaritäten des Stroms durch den elektronischen Schalter abschalten. Die Schalter werden dabei so angeordnet, dass ein Strom von einem ersten Anschluss des elektronischen Schalters zu einem zweiten Anschluss des elektronischen Schalters durch einen ersten der beiden abschaltbaren Halbleiterschalter geführt und abgeschaltet werden kann und ein Strom von dem zweiten Anschluss des elektronischen Schalters zu dem ersten Anschluss des elektronischen Schalters durch einen zweiten der beiden abschaltbaren Halbleiterschalter geführt und abgeschaltet werden kann. Für den Fall, dass parallel zum schaltenden Element des Halbleiterschalters eine Diode angeordnet ist, die dem abschaltbaren Halbleiterschalter Rückwärts-Leitfähigkeit ermöglicht, werden die beiden Halbleiterschalter in einer Reihenschaltung angeordnet. Da die schaltenden Elemente der beiden Halbleiterschalter jeweils einen Strom mit unterschiedlicher Polarität führen und abschalten können wird diese Reihenschaltung auch als antiseriell bezeichnet. Dabei sind die beiden Halbleiterschalter bezüglich Kollektor und Emitter bzw. Drain und Source Anschlüsse gegenüber gedreht. Für den bidirektionalen Betrieb können also zwei oder mehr der elektronischen Schalter antiseriell geschaltet werden, wobei typischerweise eine gerade Anzahl der elektronischen Schalter verwendet wird, von denen eine Hälfte einer Stromrichtung zugeordnet ist und die andere Hälfte der anderen Stromrichtung.

- Der erste und zweite Widerstand können durch eine Isolationsplatte oder Isolationsfolie getrennt aneinandergelegt und mittels verschraubter Platten aneinandergepresst werden. Voraussetzung hierfür ist, dass die Widerstände flächige Bereiche aufweisen, die sich aneinanderpressen lassen. Diese sind vorteilhaft, da sie es ermöglichen, die Widerstände nahe beieinander anzuordnen, was eine niedrige Induktivität ermöglicht. Beim Abschalten des Halbleiterschalters und Kommutieren eines erheblichen Stroms, beispielsweise eines Kurzschlussstroms im kA-Bereich tritt eine erhebliche mechanische Kraft zwischen den beiden Widerständen auf, die die Widerstände auseinandertreibt. Ein vergrößerter Abstand zwischen den Widerständen erhöht aber die Induktivität. Daher ist es vorteilhaft, wenn die Widerstände durch das Aneinanderpressen einen geringen Abstand bewahren.
- Der erste und/oder zweite Widerstand kann einen mäanderförmigen Teilbereich aufweisen. Mit anderen Worten ist in dem betroffenen Widerstand ein Teilbereich vorhanden, in dem das Material so geformt ist, dass der Strompfad mäanderförmig ist. Die Formung des Materials kann beispielsweise durch eine geeignete Stanzung erreicht werden. Damit oder mit anderen Mitteln können beispielsweise Lücken in das Material des Widerstands eingebracht werden, die den Strompfad in eine Mäanderform zwingen. Wird in eine rechteckige Fläche, die den Strom führt, eine Mäanderform eingebracht, entlang der der Strom fließen muss, dann wird dadurch der Strompfad verlängert und gleichzeitig sein Querschnitt verringert. Dadurch wird der elektrische Widerstand gegenüber dem freien Stromfluss in der rechteckigen Fläche deutlich erhöht. Das wiederum ermöglicht bei gegebener physischer Größe des Widerstands und einer Mindestdicke, die durch die mechanische Festigkeit gefordert ist, die Einstellung eines Widerstands im für den elektronischen Schalter benötigten Bereich. Die Mäanderform ist zweckmäßig so angeordnet, dass sich wiederum die Ströme durch die Mäander aufheben. Die Ströme der beiden Platten fließen also in genau gegensätzlicher Richtung um das Summenmagnetfeld praktisch aufzuheben. Das Größe des Summenmagnetfelds wiederum ist für die restliche Induktivität verantwortlich.

- Der erste und zweite Widerstand können direkt auf Anschlüsse des abschaltbaren Halbleiterschalters aufgeschraubt sein. Der Kondensator wiederum kann direkt auf den ersten und zweiten Widerstand aufgeschraubt sein. Hierdurch ergibt sich eine sehr niederinduktive Verbindung.
- Bei dem elektronischen Schalter kann es sich um einen Mittelspannungs-DC-Schalter handeln oder einen Niederspannungs-DC-Schalter. Als Niederspannungs-DC-Schalter kann er beispielsweise in Schiffsnetzen bei Spannungen um 500 V bis 1500 V zum Einsatz kommen. Als Mittelspannungs-DC-Schalter kann er bei Spannungen von 1500 V DC bis größer 10 kV DC zum Einsatz kommen. Besonders vorteilhaft ist die niedrige Induktivität und damit hohe Schaltgeschwindigkeit bei der Trennung von Teilnetzen, die beispielsweise auf Schiffen verwendet werden, wenn diese im Fehlerfall schnell getrennt werden müssen.
- Der Schalter kann auch für in einer HGÜ-Anwendung (Hochspannungs-Gleichstrom-Übertragung) in einer "Vielfach"-Reihenschaltung, d.h. einer Reihenschaltung einer Vielzahl von elektronischen Schaltern zum Einsatz kommen. Hierbei werden dann DC-Spannungen von bis zu 1000 kV DC erreicht.

Im Folgenden wird die Erfindung anhand der in den Figuren dargestellten Ausführungsbeispiele näher beschrieben und erläutert. Es zeigen:
- Figur 1: ein DC-Netz mit einem elektronischen Schalter,
- Figur 2: ein Ausführungsbeispiel eines elektronischen Schalters mit niederinduktivem Widerstand,
- Figur 3: einen Querschnitt des elektronischen Schalters,
- Figur 4: eine räumliche Ansicht eines Teilwiderstands des niederinduktiven Widerstands,
- Figur 5: eine räumliche Ansicht des elektronischen Schalters,
- Figuren 6 und 7: räumliche Ansichten von alternativen Formen für die Teilwiderstände,
- Figur 8: einen elektronischen Schalter mit einer Mehrzahl von Schaltblöcken,
- Figur 9: einen bidirektionalen elektronischer Schalter.

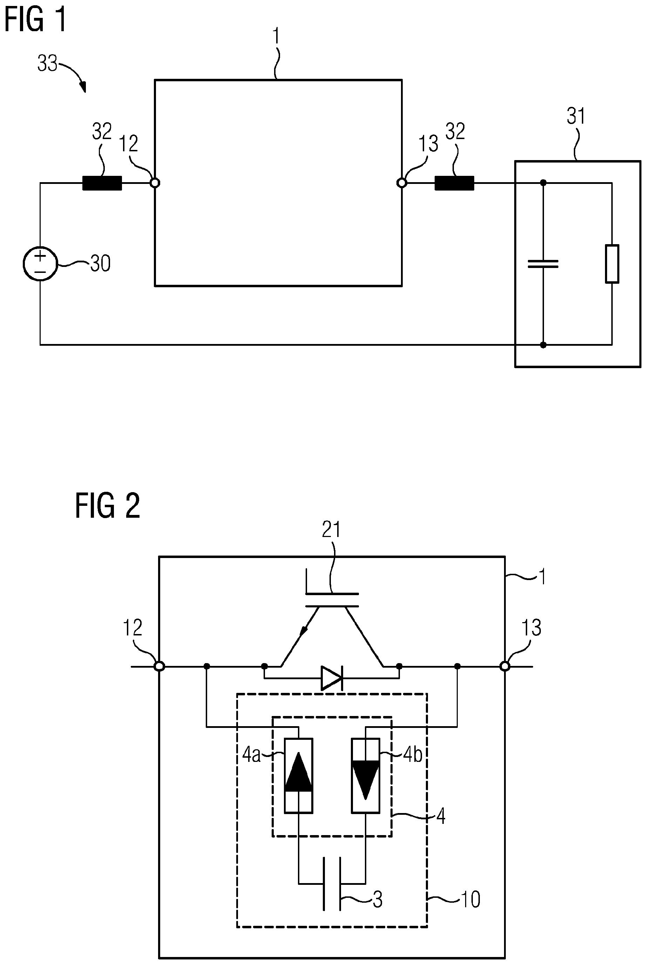

Die Figur 1 zeigt ein DC-Netz 33, das auch als Gleichspannungsnetz bezeichnet wird. Dieses versorgt aus einer DC-Quelle 30, auch als Gleichspannungsquelle bezeichnet, eine Last 31. Bei dieser Last kann es sich beispielsweise um einen Antrieb mit einem Stromrichter handeln, wobei der Stromrichter mit seinem Zwischenkreis über einen elektronischen Schalter 1 mit der DC-Quelle 30 verbunden ist.

Ein elektronischer Schalter 1 mit einem ersten Anschluss 12 und einem zweiten Anschluss 13 ist dabei in die Leitung des DC-Netzes 33 geschaltet. Der elektronische Schalter 1 kann den in der Leitung fließenden Strom abschalten. Je nach Art des elektronischen Schalters 1 kann dieser einen Strom in nur eine Richtung oder in beiden Richtungen zwischen dem ersten und dem zweiten Anschluss 12, 13 abschalten.

Die Leitungen zwischen DC-Quelle 30 und Last 31 können ganz unterschiedliche Eigenschaften bezüglich ihres induktiven Verhaltens annehmen. Dieses induktive Verhalten ist in der Darstellung mit Hilfe von Induktivitäten 32 dargestellt. Diese können sehr kleine Werte annehmen, da kein Transformator vorhanden ist, der mit seiner Induktivität strombegrenzend wirkt. Auf der anderen Seite können die Induktivitäten auch sehr große Werte aufgrund großer Kabellängen annehmen.

Für den elektronischen Schalter 1 ergeben sich daraus die Anforderungen, dass er aufgrund der geringen Induktivität und der damit einhergehenden großen Stromänderungen, insbesondere bei einem Kurzschluss, ein sehr schnelles Schaltverhalten aufweisen sollte, damit unzulässig hohe Ströme, wie sie beispielsweise bei einem Kurzschluss entstehen, sicher beherrscht werden können. Darüber hinaus muss der elektronische Schalter 1 auch in der Lage sein, bei hohen Induktivitäten sicher zu funktionieren. Große Induktivitäten speichern bei gleichen Strömen wesentlich mehr Energie. Diese Energie muss beim Abschalten eines Kurzschlusses gespeichert oder abgebaut werden, da es sonst zu Überspannungen am Leistungsschalter kommt.

Die Figur 2 zeigt ein Ausführungsbeispiel eines elektronischen Schalters 1 mit einer Überspannungsbegrenzung. Parallel zu einem abschaltbaren Halbleiterschalter 21 ist eine erste Reihenschaltung 10 angeordnet. Diese erste Reihenschaltung 10 weist einen Kondensator 3 und zwei Teilwiderstände 4a, b auf, die in einer Reihenschaltung angeordnet sind. Schaltet der abschaltbare Halbleiterschalter 21 den Strom zwischen den Anschlüssen 12, 13 des elektronischen Schalters 1 ab, so wird der durch die Induktivitäten getriebene Strom auf die erste Reihenschaltung 10 kommutiert. Der Kondensator 3 und die Widerstände nehmen die Energie aus den Induktivitäten auf. Dadurch werden die entstehenden Spannungen am Schalter 1, die sich aus der großen Stromabnahme durch das Abschalten ergeben, reduziert und eine Beschädigung des Schalters vermieden.

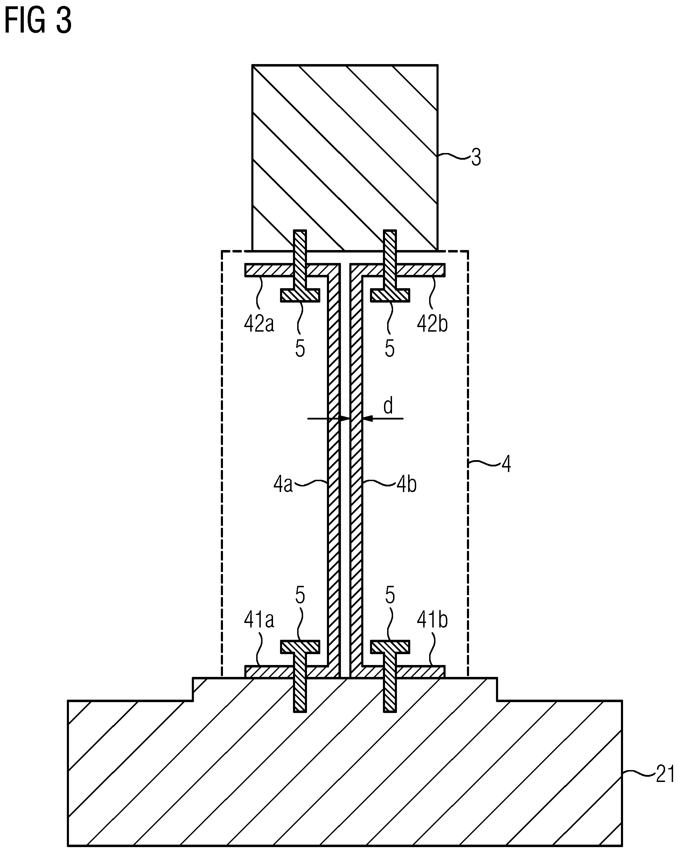

Die beiden Teilwiderstände 4a, b sind dabei wie in Figur 2 angedeutet und in Figur 3 noch deutlicher gezeigt räumlich benachbart angeordnet. Dabei ist die Anordnung derart, dass ein durch die Teilwiderstände 4a, b fließender Strom wie in Figur 2 durch Pfeile angedeutet gegenläufig ist. Dadurch heben sich die durch den fließenden Strom bewirkten Magnetfelder weitgehend auf. Die Teilwiderstände 4a, b bilden also zusammen einen Widerstand 4, der bifilar ausgestaltet ist. Der Widerstand 4 ist dadurch sehr niederinduktiv und die Kommutierung des Stroms in die Reihenschaltung 10 und somit zum Kondensator 3 kann dadurch sehr schnell erfolgen. Da die Ströme in beiden Widerständen 4a, b gegenläufig sein müssen, um einen niederinduktiven Widerstand 4 zu erreichen, müssen von den beiden Widerständen 4a, 4b je einer vor und der andere nach dem Kondensator 3 in der Reihenschaltung 10 angeordnet sein. Mit anderen Worten muss in der Reihenschaltung 10 die Reihenfolge R-C-R eingehalten sein.

Eine Möglichkeit für den Aufbau des bifilaren Widerstands 4 ist im Schnittbild der Figur 3 dargestellt. Die beiden Teilwiderstände 4a, b sind dabei im Querschnitt gezeigt und haben jeweils die Form eines eckigen C oder einer eckigen Klammer [. Beide Teilwiderstände 4a, b sind dabei mit dem Rücken dieser Form zueinander angeordnet, sodass sich in dem in Figur 3 gezeigten Querschnitt die Form zweier auseinander zeigender eckiger Klammern] [ergibt. An einem Endbereich 41a, 41b ist jeder der Teilwiderstände 4a, b mit einer Schraubverbindung 5 an einer Kontaktfläche des Halbleiterschalters 21 angebracht. Der jeweils andere Endbereich 42a, 42b ist mit einer Schraubverbindung 5 mit dem Kondensator 3 verbunden. In Verbindung mit einem V4A-Stahl als Material für den Widerstand 4 ergibt sich ein mechanisch stabiler Aufbau, bei dem der Kondensator 3 vom Widerstand 4 getragen wird. Die Dicke d des Widerstands 4 liegt dabei im Millimeter-Bereich, idealerweise zwischen 0,5 mm und 3 mm.

In anderen Ausführungsbeispielen können andere Materialien für die Teilwiderstände 4a, b verwendet werden, beispielsweise das Widerstandsmaterial Konstantan. Auch nichtmetallische Materialien wie Kohlenstoff können verwendet werden. Dabei kann die Dicke d der Teilwiderstände 4a, b größer oder kleiner als die oben genannten Werte sein.

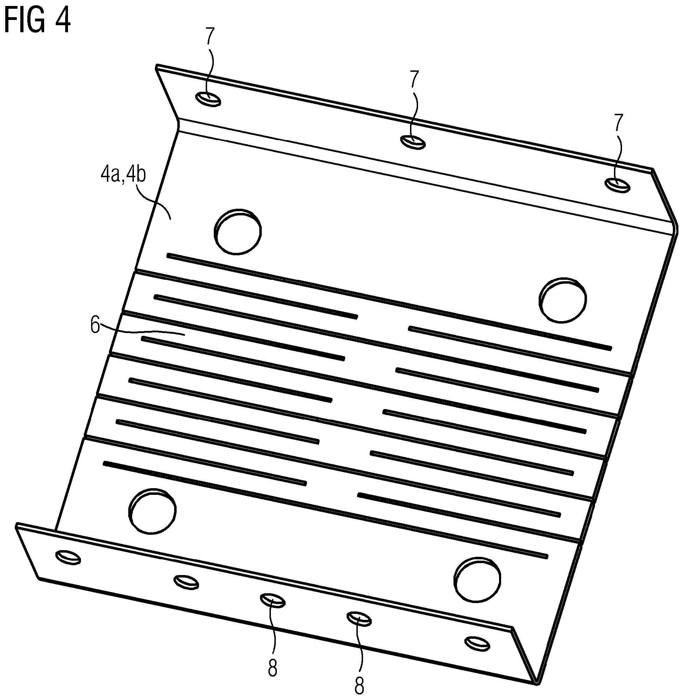

Figur 4 zeigt eine räumliche Ansicht eines der Teilwiderstände 4a, b. Der Durch Stanzung hergestellte Widerstand 4a, b umfasst dabei in einem mittleren Bereich eine Mäanderstruktur 6. In dieser Mäanderstruktur 6 wird der elektrische Strom auf eine mäanderförmige Bahn gezwungen und dadurch die Leiterlänge deutlich erhöhte, während gleichzeitig die Leiterbreite verringert wird. Durch die Mäanderstruktur 6 wird also insgesamt der elektrische Widerstand des Widerstands 4a, b erhöht. Das ist vorteilhaft, um den gewünschten elektrischen Widerstand von zwischen 0,1 Ohm und 0,5 Ohm einzustellen. Dieser würde ohne die Mäanderstruktur 6 eine so geringe Materialdicke erfordern, dass die mechanische Stabilität schwieriger zu erreichen wäre. Figur 4 zeigt weiterhin Bohrungen 7, die der Verschraubung mit dem Halbleiterschalter 21 dienen und Bohrungen 8 für die Verbindung mit dem Kondensator 3. Die Größe des Rückens des Widerstands 4a, 4b beträgt bevorzugt zwischen 10 cm x 10 cm und 20 cm x 20 cm.

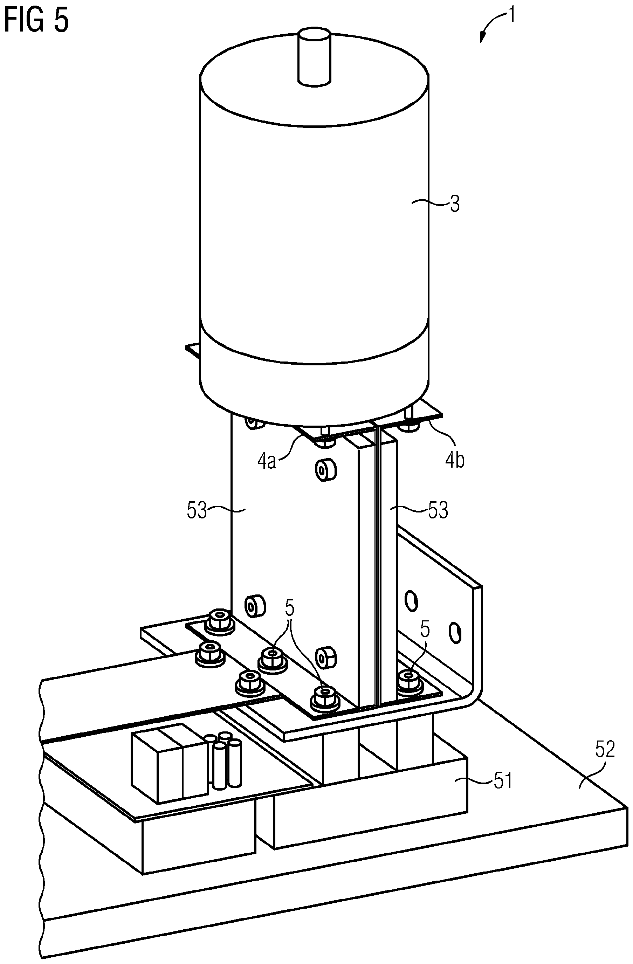

Figur 5 zeigt einen kompletten Aufbau eines elektronischen Schalters 1 in einer räumlichen Ansicht. Der elektronische Schalter 1 umfasst dabei ein Halbleiterschaltermodul 51, das auf einem Kühler 52 angeordnet ist. Auf der Oberseite des Halbleiterschaltermoduls 51 ist der Widerstand 4 angeordnet und auf diesem wiederum der Kondensator 3. Bei der Abschaltung eines Stroms durch den elektronischen Schalter 1 wird in kurzer Zeit ein hoher Stromfluss in den Widerstand 4 kommutiert. Dadurch wird eine erhebliche mechanische Kraft auf die Teilwiderstände 4a, b erzeugt, deren Richtung derart ist, dass die Teilwiderstände 4a, b auseinandergedrückt werden. Um den niederinduktiven Aufbau zu erhalten, muss aber der Abstand der Teilwiderstände 4a, b gering bleiben. Daher sind die beiden Teilwiderstände 4a, b durch verschraubte Kunststoff-Platten 53 aneinander gepresst, wobei zwischen den Widerständen 4a, 4b eine Isolierfolie 9 angeordnet ist. Dadurch wird sichergestellt, dass der mechanische Aufbau auch bei der Abschaltung erhalten bleibt.

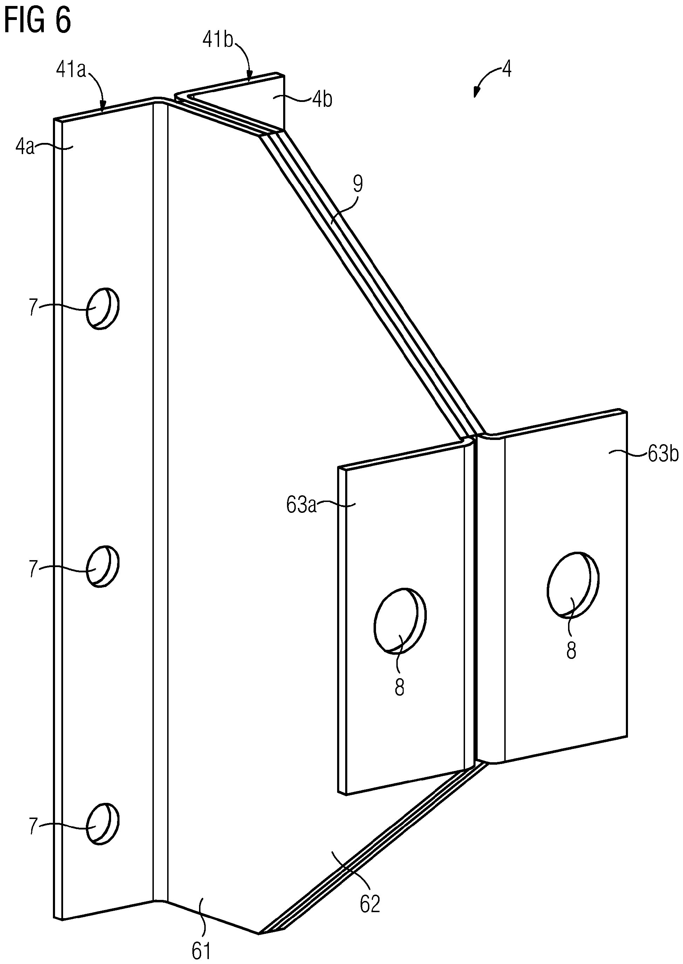

Figur 6 zeigt einen alternativen Aufbau des Widerstands 4. Dabei ist die Form der Teilwiderstände 4a, 4b verändert. Wie bei der in Fig.5 dargestellten Form weisen die Teilwiderstände einen ersten Endbereich 41a, 41b auf, der für die Anbringung am Halbleiterschaltermodul 51 geeignet geformt ist und Bohrungen 7 aufweist. An diesen Endbereich 41a, 41b schließt sich ein rechteckigförmiger Bereich 61 an, der an einen trapezförmigen Bereich 62 angrenzt. In diesem trapezförmigen Bereich verjüngen sich die Teilwiderstände 4a, 4b zum zweiten Endbereich 42a, 42b hin, der dadurch eine verminderte Breite aufweist und jeweils nur eine Bohrung 8 zum Anschluss des Kondensators 3 bei jedem der Teilwiderstände 4a, 4b. Wie bei allen diesen Widerständen 4 sind die Teilwiderstände 4a, 4b getrennt durch die Isolierfolie 9, die analog zu den Teilwiderständen 4a, 4b geformt ist, also sich ebenfalls verjüngt.

Die sich verjüngende Form der Teilwiderstände 4a, 4b von Fig. 6 erhöht den elektrischen Widerstand der Teilwiderstände 4a, 4b. Trotzdem ist es vorteilhaft, auch bei diesen Teilwiderständen 4a, 4b eine Mäanderform vorzusehen, um den elektrischen Widerstand in den Bereich von zwischen 0,1 Ohm und 0,5 Ohm zu bringen, der für die Funktion des elektronischen Schalters zweckmäßig ist.

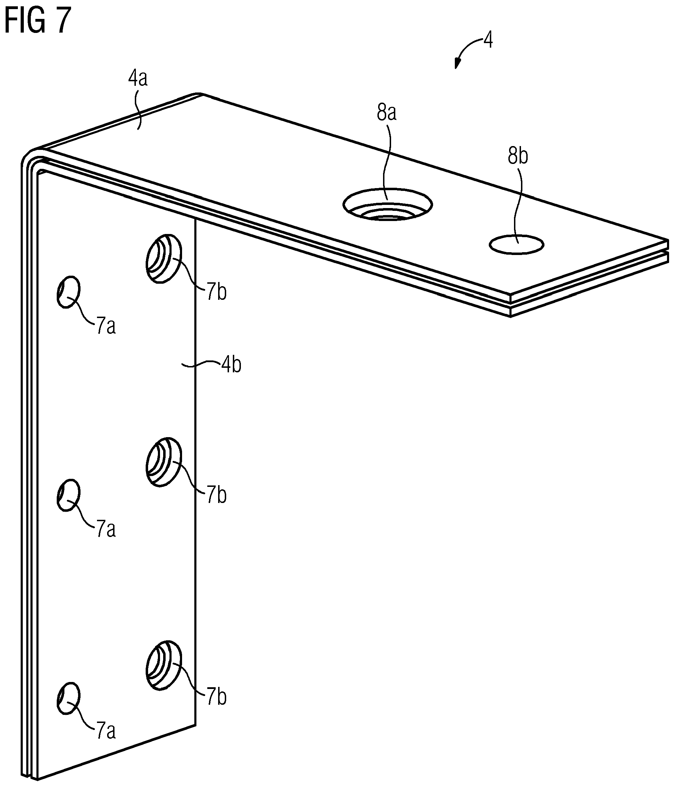

Figur 7 zeigt einen weiteren alternativen Aufbau des Widerstands 4. Dabei ist die Form der Teilwiderstände 4a, 4b verändert. Während bei den bisher beschriebenen Formen der Teilwiderstände 4a, 4b im Querschnitt die Form zweier eckiger Klammern] [realisiert war, ist die Form gemäß Figur 7 eine LL-Form, d.h. der Querschnitt entspricht zwei ineinander gestellten L-Formen, wobei einer der Teilwiderstände 4a, 4b das außenliegende L bildet und der andere der Teilwiderstände 4a, 4b das innenliegende L. Dabei dient ein erster Schenkel der L-Form dem Anschluss an das Halbleiterschaltermodul 51 und weist wiederum Bohrungen 7a, b auf. Da die Teilwiderstände 4a, 4b aufeinander liegen müssen, unterscheiden sich die Bohrungen 7a, b, um auf einer Seite den Anschluss des außenliegenden Teilwiderstands 4a mit den Bohrungen 7b und auf der anderen Seite den Anschluss des innenliegenden Teilwiderstands 4b mit den Bohrungen 7a zu erlauben.

Der zweite Schenkel bildet die Verschienung zum Kondensator 3 und weist zum Ende hin Bohrungen 8a, b zur Verschraubung des Kondensators 3 auf. Die Bohrungen 8a, b sind wiederum unterschiedlich gestaltet, um einmal den innenliegenden Teilwiderstand 4b und einmal den außenliegenden Teilwiderstand 4a zu kontaktieren. Auch der Widerstand 4 der Figur 7 weist eine zwischen den Teilwiderständen 4a, 4b angeordnete Isolierfolie 9 zur elektrischen Isolierung der Teilwiderstände 4a, 4b auf.

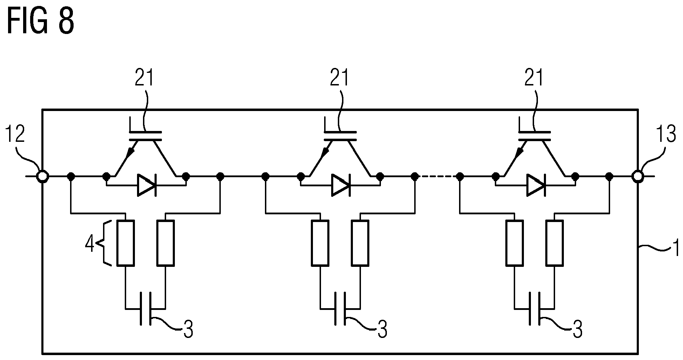

Um verschiedenen Anforderungen des DC-Netzes 33 gerecht zu werden, ist es möglich, zwei oder mehr der Halbleiterschalter 21 mit ihrer zugeordneten Reihenschaltung aus den Teilwiderständen 4a, 4b und dem Kondensator 3 in Serie zu schalten. Eine solcher elektronischer Schalter 1 ist in Figur 8 dargestellt. Es werden also nicht etwa mehrere Halbleiterschalter 21 in Serie geschaltet und dazu wiederum parallel ein Kondensator 3. Vielmehr wird der gesamte Block aus Halbleiterschalter 21 und Reihenschaltung aus den Teilwiderständen 4a, 4b und dem Kondensator 3 vervielfacht und in Serie zueinander geschaltet. Hierdurch bleibt die sehr niederinduktive Anbindung des Widerstands 4 an den jeweiligen Halbleiterschalter 21 erhalten. Würden mehrere Halbleiterschalter 21 parallel zum Kondensator 3 geschaltet, würden zusätzliche elektrische Leiter oder Stromschienen im Kommutierungskreis erforderlich, die die Induktivität erhöhen würden.

Die Verbindung zwischen einem Block, der von einem Halbleiterschalter 21 und der zugeordneten Reihenschaltung aus den Teilwiderständen 4a, 4b und dem Kondensator 3 gebildet wird, und dem nächsten solchen Block, kann dagegen hochinduktiv sein ohne besondere Nachteile für den elektronischen Schalter 1.

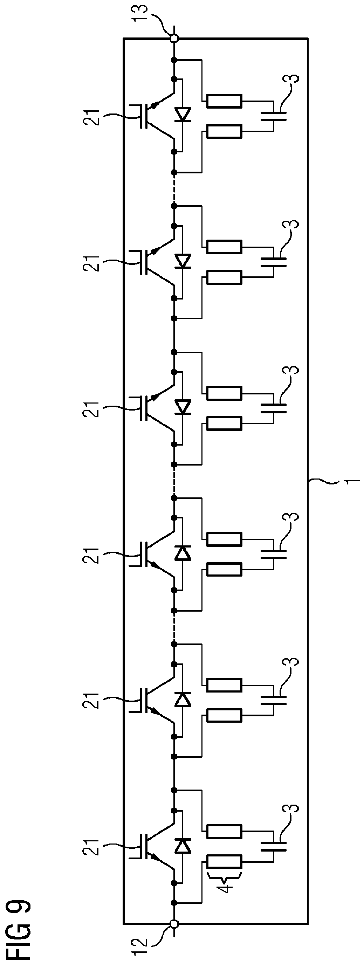

Um einen bidirektionalen elektronischen Schalter 1 zu schaffen und somit Strom beider Richtungen abschalten zu können, kann der aus Figur 8 ersichtliche elektronische Schalter 1 ergänzt werden durch eine Anzahl von weiteren Blöcken aus Halbleiterschalter 21 mit ihrer zugeordneten Reihenschaltung aus den Teilwiderständen 4a, 4b und dem Kondensator 3, wobei die Halbleiterschalter 21 antiseriell angeordnet sind zu den bereits vorhandenen Halbleiterschaltern 21. Bevorzugt wird dabei dieselbe Zahl an Blöcken für beide Stromrichtungen verwendet. Ein solcher elektronischer Schalter 1 ist in Figur 9 gezeigt. Beispielsweise kann ein so gebildeter elektronischer Schalter 1 acht Blöcke für eine erste Stromrichtung und acht weitere Blöcke für die andere Stromrichtung aufweisen.

Zusammenfassend betrifft die Erfindung einen elektronischen Schalter mit einem, insbesondere genau einem, abschaltbaren Halbleiterschalter, wobei der elektronische Schalter einen Kondensator und einen Widerstand aufweist, wobei der Kondensator und der Widerstand in einer Reihenschaltung angeordnet sind, wobei die Reihenschaltung aus dem Kondensator und dem Widerstand parallel zum abschaltbaren Halbleiterschalter angeordnet ist. Zur Verbesserung des elektronischen Schalters, insbesondere bezüglich seines Schaltverhaltens, wird vorgeschlagen, dass der Widerstand zwei Teilwiderstände umfasst und als bifilarer Widerstand aufgebaut ist, wobei in der Reihenschaltung die Elemente in der Reihenfolge Teilwiderstande, Kondensator, Teilwiderstand angeordnet sind.

### Bezugszeichen

- 1: elektronischer Schalter
- 12, 13: Anschlüsse
- 31: Last
- 33: DC-Netz
- 32: Leitungsinduktivität
- 30: DC-Spannungsquelle
- 3: Kondensator
- 4: Widerstand
- 4a, 4b: Teilwiderstände
- 21: Halbleiterschalter
- 5: Verschraubung
- 41a, b: Endbereich
- 42a, b: Endbereich
- d: Dicke
- 6: Mäanderbereich
- 7, 8: Bohrungen
- 52: Kühlung
- 51: Halbleiterschaltermodul
- 53: Kunststoffplatten
- 61: Rechteckförmiger Bereich
- 62: trapezförmiger Bereich
- 63a, b: Endbereich
- 7a, 7b: Bohrungen
- 8a, 8b: Bohrungen
- 9: Isolierfolie

## Patentansprüche

1. Elektronischer Schalter (1), aufweisend
- einen abschaltbaren Halbleiterschalter (21),
- eine Reihenschaltung, die parallel zum abschaltbaren Halbleiterschalter (21) angeordnet ist und einen ersten Widerstand (4a), einen Kondensator (3) und einen zweiten Widerstand (4b) umfasst, die in der Reihenfolge R-C-R angeordnet sind, wobei der erste und zweite Widerstand (4a, b) zusammen als bifilarer Widerstand (4) aufgebaut sind.

2. Elektronischer Schalter (1) nach Anspruch 1, bei dem der bifilare Widerstand (4) wenigstens eines der folgenden Materialien umfasst: eine Eisenlegierung, insbesondere V4A-Stahl; Konstantan; Kohlenstoff.

3. Elektronischer Schalter (1) nach Anspruch 1 oder 2, bei dem der erste und zweite Widerstand (4a, b) mittels Stanzung oder Laserstrahlschneiden hergestellt sind.

4. Elektronischer Schalter (1) nach einem der vorangehenden Ansprüche, bei dem der bifilare Widerstand (4) als mechanischer Träger für den Kondensator (3) ausgebildet ist.

5. Elektronischer Schalter (1) nach einem der vorangehenden Ansprüche, bei dem der erste und zweite Widerstand (4a, b) jeweils die Form eines Vierecks, insbesondere eines Rechtecks, aufweisen, bei dem zwei einander gegenüberliegende Kanten zu einer Seite hin um 90° umgebogen sind, insbesondere mit einem Querschnitt der Form [.

6. Elektronischer Schalter (1) nach Anspruch 5, bei dem der erste und zweite Widerstand (4a, b) durch eine Isolationsplatte oder Isolationsfolie (9) getrennt aneinandergelegt und mittels verschraubter Platten (53) aneinandergepresst sind.

7. Elektronischer Schalter (1) nach Anspruch 5 oder 6, bei dem der erste und zweite Widerstand (4a, b) zusammen einen Querschnitt der Form] [aufweisen.

8. Elektronischer Schalter (1) nach einem der vorangehenden Ansprüche, bei dem der erste und zweite Widerstand (4a, b) jeweils einen mäanderförmigen Teilbereich (6) aufweisen, wobei die mäanderförmigen Teilbereiche (6) so zueinander angeordnet sind, dass diese Mäander wiederum eine bifilare Anordnung bilden.

9. Elektronischer Schalter (1) nach einem der vorangehenden Ansprüche, bei dem der erste und zweite Widerstand (4a, b) jeweils L-förmig geformt sind, wobei die beiden L-Formen ineinandergestellt sind zur Bildung des bifilaren Widerstands (4) .

10. Elektronischer Schalter (1) nach einem der vorangehenden Ansprüche, bei dem der erste und zweite Widerstand (4a, b) direkt auf Anschlüsse des abschaltbaren Halbleiterschalters (21, 51) aufgeschraubt sind.

11. Elektronischer Schalter (1) nach einem der vorangehenden Ansprüche, bei dem der Kondensator (3) direkt auf den ersten und zweiten Widerstand (4a, b) aufgeschraubt ist.

12. Schalteinrichtung mit einer ersten Zahl von elektronischen Schaltern (1) nach einem der vorangehenden Ansprüche, die in Serie zueinander geschaltet sind.

13. Schalteinrichtung nach Anspruch 12 mit einem oder mehreren weiteren elektronischen Schaltern (1) nach einem der Ansprüche 1 bis 11, die antiseriell zu der ersten Zahl von elektronischen Schaltern (1) geschaltet sind, wobei insbesondere die Zahl der elektronischen Schalter (1), die einer ersten Stromrichtung zugeordnet sind, gleich der Zahl der elektronischen Schalter (1) ist, die der anderen Stromrichtung zugeordnet sind.

14. Schiffsnetzwerk mit einem oder mehreren elektronischen Schaltern (1) nach einem der Ansprüche 1 bis 11 und/oder einer oder mehreren Schalteinrichtungen nach Anspruch 12 oder 13.

15. Hochspannungs-Gleichstrom-Übertragungsnetzwerk mit wenigstens einer Schalteinrichtung nach Anspruch 12 oder 13.
